(19) **Europäisches Patentamt European Patent Office Office européen des brevets**

(11) **EP 2 400 659 B1**

(12) **FASCICULE DE BREVET EUROPEEN**

(45) Date de publication et mention
de la délivrance du brevet:
**12.12.2012 Bulletin 2012/50**

(51) Int Cl.:
*H02P 29/02* (2006.01)          *H02P 6/18* (2006.01)
*H02K 29/12* (2006.01)

(21) Numéro de dépôt: **11305784.8**

(22) Date de dépôt: **21.06.2011**

(54) **Dispositif électrique comportant un moteur électrique à courant alternatif et un onduleur de commande ainsi qu'un procédé de mesure de la force électromotrice de ce dispositif**

Elektrische Vorrichtung, die einen Wechselstrommotor und einen Steuerumrichter umfasst, sowie ein Verfahren zur Messung der elektromotorischen Kraft dieser Vorrichtung

Electric device comprising an alternating current electric motor and a control inverter and a method for measuring the electromotive force of this device

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.06.2010 FR 1055085**

(43) Date de publication de la demande:
**28.12.2011 Bulletin 2011/52**

(73) Titulaire: **Valeo Systèmes de Contrôle Moteur 95832 Cergy Saint Christophe (FR)**

(72) Inventeurs:
• **Bouchez, Boris**
**95800 Cergy le Haut (FR)**
• **De Sousa, Luis**
**95670 Eragny sur Oise (FR)**

(56) Documents cités:
**EP-A2- 1 564 882      US-A- 4 654 566**
**US-A- 5 708 337      US-A1- 2003 193 306**

**EP 2 400 659 B1**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

La présente invention concerne un dispositif électrique comportant un moteur électrique à courant alternatif et un onduleur de commande ainsi qu'un procédé associé de mesure de la force électromotrice de ce dispositif et se situe dans le domaine des moteurs électriques à courant alternatif.

L'invention trouvera en particulier application dans le domaine des automobiles électriques notamment pour des onduleurs de traction et leur moteur électrique associé ou encore pour des onduleurs de compresseur de climatisation et leur moteur électrique associé.

Toutefois, bien que particulièrement prévus pour une telle application, le dispositif et le procédé associé pourront être utilisés dans d'autres domaines comme par exemple la direction assistée électriquement ou pour des moteurs électriques de ventilateurs.

ARRIERE PLAN DE L'INVENTION

Classiquement un véhicule électrique est équipé de batteries haute tension délivrant un courant continu à un onduleur qui transforme ce courant continu en un courant alternatif permettant d'alimenter un moteur électrique, ce dernier assurant la mise en mouvement du véhicule.

Pour la commande du moteur et en particulier pour commander les commutateurs de l'onduleur, il est nécessaire de connaître la position angulaire du moteur afin d'alimenter chaque phase du moteur au bon moment pour obtenir un couple d'entraînement optimal.

Ceci est généralement réalisé par des capteurs de position, par exemple des encodeurs / capteurs à effet Hall, disposé sur l'axe de rotation du moteur électrique comme cela est par exemple décrit dans le document US 6 307 336.

Toutefois, il s'avère que ces détecteurs de position sont un point faible du système et conduisent à l'arrêt du véhicule en cas de défaillance du capteur. De plus, ces capteurs sont couteux.

Dans le document EP 1564882, il a été proposé des enroulements auxiliaires pour mesurer directement la force électromotrice de chaque phase du moteur.

Toutefois, cette solution conduit à des modifications complexes du moteur électrique.

Par ailleurs, comme pour le capteur de position, on ne sait pas si par exemple l'absence du signal de mesure provient d'une défaillance de ce montage auxiliaire ou d'une défaillance du moteur même.

Le document US 7 489 097 décrit un système électrique comportant un moteur à courant alternatif et un onduleur de commande permettant de mesurer directement la force électromotrice des phases du moteur. Pour ce faire, l'onduleur doit commander le moteur de façon particulière de sorte que la phase dont ont souhaite mesurer la FEM, ne soit pas alimentée lors de la mesure.

Il s'avère que la commande trapézoïdale des phases permet d'avoir deux phases alimentées et une non alimentée. Dans ce cas, le courant est nul pendant une période suffisamment longue pour mesurer la FEM et détecter son passage à zéro.

Cependant, cette façon ne convient par exemple pas pour des commandes sinusoïdales du moteur.

OBJET DE L'INVENTION

La présente invention a pour but de proposer un dispositif et un procédé permettant d'accéder directement à la force électromotrice des phases du moteur, ceci sans capteur de position.

RESUME DE L'INVENTION

A cet effet, l'invention à pour objet un dispositif électrique comportant un moteur électrique à courant alternatif et un onduleur de commande de la / des phase(s) du moteur, caractérisé en ce que le moteur comporte sur au moins un enroulement d'au moins une phase un point de mesure d'une tension par rapport à un potentiel prédéfini, le point de mesure étant choisi de manière à ce qu'il divise l'enroulement en une première et une seconde parties tel que les forces électromotrices induites des deux parties soient déphasées l'une par rapport à l'autre et des moyens de mesure de la tension entre le point de mesure et le potentiel prédéfini.

Grâce au fait de choisir un point de mesure directement au niveau des enroulements des phases et de manière à ce qu'il divise l'enroulement en une première et une seconde parties telles que les forces électromotrices induites des deux parties soient déphasées l'une par rapport à l'autre, on devient indépendant de la forme des commandes du moteur. Ainsi, dans le dispositif, une mesure directe de la force électromotrice d'une phase peut être réalisée même quand le courant parcourant la phase est non nul. Les phases du dispositif ne sont pas soumises à une condition de nullité du courant pour une mesure de leur force électromotrice.

Selon un aspect, les moyens de mesure de la tension entre le point de mesure et le potentiel prédéfini sont configurés de manière à mesurer la tension pendant que l'onduleur ait commuté les phases concernées en roue libre.

Selon un autre aspect, les enroulements du moteur sont des enroulements à point milieu et le point de mesure est le point milieu de l'enroulement.

Par ailleurs, on peut prévoir que la force électromotrice induite dans chacune des deux parties d'un enroulement est d'amplitude sensiblement égale.

Puis, l'onduleur peut être configuré pour commuter de façon synchronisée l'ensemble des phases en roue libre pour permettre la mesure simultanée des tensions pour chaque phase du moteur.

Selon un aspect, l'onduleur est un onduleur triphasé standard.

Selon un développement, l'onduleur est un onduleur pont triphasé en H.

Le moteur électrique à courant alternatif est par exemple un moteur électrique polyphasé dont le pas mécanique correspond à une fraction de l'angle mécanique.

Le moteur électrique à courant alternatif peut être un moteur électrique triphasé à courant alternatif.

Le dispositif peut comprendre une unité de contrôle du moteur reliée auxdits moyens de mesure et configurée pour déduire du résultat de mesure pour chaque phase la force électromotrice pour chacune des phases du moteur et pour commander l'onduleur en fonction des forces électromotrices mesurées.

L'unité de contrôle est par exemple configurée pour déduire la position angulaire du moteur à partir des passages à zéro des forces électromotrices de chaque phase.

Un autre objet de l'invention vise un procédé de mesure de la force électromotrice d'un dispositif électrique comportant un moteur électrique à courant alternatif et un onduleur de commande de la / des phase(s) du moteur, caractérisé en ce que

- on mesure une tension entre le point de mesure d'un enroulement d'au moins une phase et un potentiel prédéfini, le point de mesure étant choisi de manière à ce qu'il divise l'enroulement en une première et une seconde parties telles que les forces électromotrices induites des deux parties soient déphasées l'une par rapport à l'autre.

Grâce au fait de choisir un point de mesure directement au niveau des enroulements des phases et de manière à ce qu'il divise l'enroulement en une première et une seconde parties telles que les forces électromotrices induites des deux parties soient déphasées l'une par rapport à l'autre, on devient indépendant de la forme des commandes du moteur. Ainsi, le procédé permet une mesure directe de la force électromotrice d'une phase même quand le courant parcourant la phase est non nul. La mesure de la force électromotrice d'une phase n'est pas soumise à une condition de nullité du courant.

Selon un aspect, on mesure une tension entre le point de mesure d'un enroulement d'au moins une phase et un potentiel prédéfini pendant que l'onduleur ait commuté les phases concernées en roue libre.

Selon un autre aspect, les enroulements du moteur sont des enroulements à point milieu et le point de mesure est le point milieu de l'enroulement.

On peut par exemple prévoir que la force électromotrice induite dans chacune des deux parties d'un enroulement est d'amplitude sensiblement égale.

On peut commuter de façon synchronisée, par exemple par une modulation de la largeur d'impulsion, l'ensemble des phases en roue libre pour permettre la mesure simultanée des tensions pour chaque phase du moteur.

L'onduleur est par exemple un onduleur triphasé standard ou un onduleur pont triphasé en H.

Le moteur électrique à courant alternatif est par exemple un moteur électrique polyphasé dont le pas mécanique correspond à une fraction de l'angle électrique.

Le moteur électrique à courant alternatif peut être un moteur électrique triphasé.

Selon un aspect, on déduit des mesures de tension pour chacune des phases la force électromotrice pour chacune des phases du moteur et on commande l'onduleur en fonction des forces électromotrices mesurées.

Selon un autre aspect, on déduit la position angulaire du moteur à partir des passages à zéro des forces électromotrices de chaque phase.

On peut déduire de la mesure des forces électromotrices de chaque phase du moteur un diagnostic et on peut générer un signal d'alerte en cas de défaillance d'une des phases.

BREVE DESCRIPTION DES DESSINS

La présente invention sera mieux comprise à la lecture d'un exemple détaillé de réalisation en référence aux dessins annexés, fournis à titre d'exemple non limitatif, parmi lesquels :

- la figure 1 représente de manière schématique un premier exemple de réalisation du dispositif,
- la figure 2 représente de manière schématique un détail du dispositif de la figure 1,
- la figure 3 montre un graphe de commande PWM pour un dispositif selon la figure 1;

- la figure 4 est une représentation graphique vectorielle des mesures de la force électromotrice d'un moteur triphasé,
- la figure 5 représente de manière schématique un deuxième exemple de réalisation du dispositif,
- la figure 6 représente de manière schématique le circuit de la figure 5 dans lequel l'onduleur est commuté pour permettre de mesurer des tensions points milieu,
- la figure 7 est un schéma simplifié d'un moteur électrique à courant alternatif à pas fractionnaire,
- la figure 8 montre un premier exemple de câblage du moteur de la figure 7,
- la figure 9 montre un second exemple de câblage du moteur de la figure 7,
- la figure 10 montre sur un graphique un exemple représentatif des mesures de la force électromotrice en fonction de la vitesse d'un véhicule automobile équipé du dispositif selon l'invention,
- la figure 11 montre sur un graphique l'évolution temporelle des forces électromotrices des phases d'un moteur triphasé pour la détection des passages à zéro, et
- la figure 12 montre le délai entre deux passages à zéro des FEM mesurées en fonction de la vitesse.

## DESCRIPTION DETAILLEE DE L'INVENTION

Sur toutes les figures, les éléments identiques portent les mêmes numéros de référence.

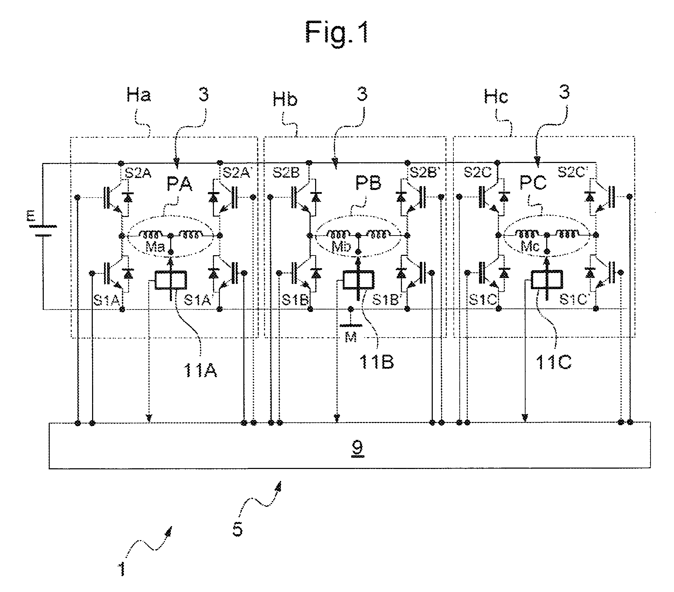

Sur la figure 1, on voit représenté un dispositif 1 selon l'invention comportant d'une part un moteur électrique 3 à courant alternatif et d'autre part un onduleur de commande 5 de la / les phases PA, PB et PC du moteur 3.

Par moteur électrique, on entend une machine électrique qui transforme une énergie électrique en un mouvement mécanique lorsqu'il est alimenté en courant et qui peut aussi transformer un mouvement mécanique en énergie électrique (générateur de courant).

Dans le présent exemple, un moteur électrique 3 est un moteur triphasé sans point neutre dont les trois phases PA, PB et PC sont réalisées chacune par des enroulements à point milieu Ma, Mb, et Mc. On comprend donc que le moteur est seulement partiellement représenté sur cette figure 1 par ses enroulements faisant office d'inductances.

L'onduleur de commande 5 des phases du moteur est sur cet exemple un onduleur triphasé à pont en H.

Dans ce mode de réalisation, l'onduleur comporte trois ponts en H, Ha, Hb et Hc.

Chaque pont en H comporte quatre interrupteurs Si,j (i=1,2 ; j= A, A', B, B', C, C'), l'index i=1 étant représentatif de la partie inférieure du pont, également appelé pied de pont, et l'index i=2 de la partie supérieure du pont. L'index j, avec ou sans prime, est représentatif de la phase auquel appartient l'interrupteur.

Les interrupteurs Si,j (i=1,2; j= A, A', B, B', C, C') sont des interrupteurs de puissance, par exemple du type IGBT pour transistor bipolaire à porte isolée (« insulated gate bipolar transistor (IGBT) ) en anglais» qui correspond à un transistor hybride, regroupant un transistor à effet de champ à grille métal-oxyde (« metal-oxyd semiconductor field effect transistor (MOSFET) » en anglais) en entrée et un transistor bipolaire en sortie.

Le terme « structure de pont en H » ou « pont en H » correspond à un circuit électrique ou électronique connu en soi.

En ce qui concerne par exemple le pont en H, Ha, il comporte les quatre éléments de commutation S1A, S2A, S1A' et S2A' généralement disposés schématiquement sous forme d'un H comme représenté sur la figure 1, les deux branches verticales étant formées respectivement par les éléments de commutation S1A, S2A d'une part et S1A' S2A' d'autre part et disposées de part et d'autre de la branche horizontale du H qui correspond à la charge du pont, c'est-à-dire à l'enroulement de la phase PA d'un moteur électrique 1.

Chaque interrupteur Si,j est relié à une unité de contrôle 9 qui applique des commandes PWM (Pulse Width Modulation, en français : modulation à largeur d'impulsions) pour permettre la réalisation de diverses fonctions, comme par exemple la rotation du moteur dans un sens ou dans l'autre pour la propulsion d'un véhicule automobile.

Le circuit est raccordé à une source de tension E continue. Dans le cadre d'une application de ce circuit à un véhicule automobile, il s'agit par exemple de moyens d'accumulation tels qu'une batterie de puissance.

Le moteur 3 comporte sur au moins un enroulement d'au moins une phase un point de mesure d'une tension par rapport à un potentiel prédéfini, le point de mesure étant choisi de manière à ce qu'il divise l'enroulement en une première et une seconde parties telles que les forces électromotrices induites des deux parties soient déphasées l'une par rapport à l'autre.

Dans le présent exemple, ces points de mesure sont avantageusement confondus avec les points milieux Ma, Mb et Mc des enroulements des phases PA, PB et PC.

Le dispositif selon l'invention comporte en outre des moyens 11A, 11B et 11C de mesure de la tension entre les points de mesure Ma, Mb et Mc et un potentiel prédéfini, par exemple la masse M du circuit, pendant que l'onduleur ait par exemple commuté les phases concernées PA, PB, PC en roue libre.

Le fait de commuter les phases PA, PB et PC en roue libre est facultatif, mais présente l'avantage d'éliminer l'offset.

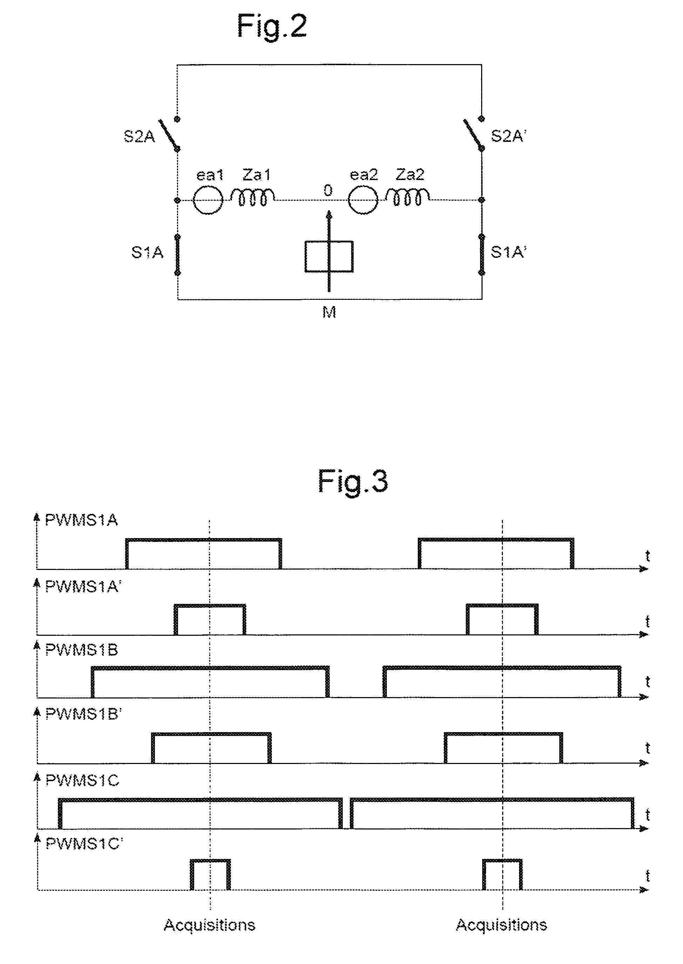

Plus en détail, on se réfère à la figure 2 qui représente à titre exemplaire le pont Ha en détail dont les éléments de commutation ont été représentés schématiquement par des interrupteurs.

Comme on le constate, les interrupteurs du pied de pont, c'est-à-dire les interrupteurs S1A et S1A' sont fermés, c'est-à-dire que la phase A ait été commuté par l'onduleur 5 en roue libre.

La première partie de l'enroulement est désignée par son impédance Za1 et la deuxième partie par son impédance Za2.

Dans ce cas, on peut poser les équations suivantes :

$$\begin{cases} V_{OM} = -e_{a1} - Z_{a1} * i_a \\ e_{a2} + Z_{a2} * i_a + e_{a1} + Z_{a1} * i_a = 0 \end{cases}$$

où

- $V_{OM}$ est la tension mesurée entre le point milieu d'un enroulement d'une phase et la masse du circuit,
- $e_{a1}$ est la force électromotrice partielle induite dans la première partie d'impédance Za1,
- $e_{a2}$ est la force électromotrice partielle induite dans la deuxième partie d'impédance Za2,
- $i_a$ est le courant induit lorsque le pont en H est commuté en roue libre comme montré sur la figure 2.

En supposant de manière simplificatrice que Za1= Za2=Z (Il est à noter que Za1 peut être différent de Za2), on obtient :

$$\begin{cases} V_{OM} = -e_{a1} - Z * i_a \\ Z * i_a = -\dfrac{e_{a2} + e_{a1}}{2} \end{cases} \Rightarrow \begin{cases} V_{OM} = \dfrac{e_{a2} - e_{a1}}{2} \end{cases}$$

Comme cela a été décrit ci-dessus, le point de mesure a été choisi de manière que les forces électromotrices partielles $e_{a1}$ et $e_{a2}$ soient déphasées l'une de l'autre. Cela peut être obtenu de différentes manières, en particulier en utilisant un moteur électrique à courant alternatif polyphasé dont le pas mécanique correspond à une fraction de l'angle électrique ( pour le présent exposé, on appelle ce type de moteur un moteur électrique à pas fractionnaire) comme cela sera expliqué plus en détail plus loin.

Pour une simplification de calcul, on suppose que $e_{a1}$ et $e_{a2}$ de chaque demi-bobine d'une phase soient égales en amplitude (même induction, même nombre de spires) mais présentent un déphasage entre elles.

Ceci reste valable même si $e_{a1}$ et $e_{a2}$ contiennent des harmoniques dont les déphasages sont les mêmes pour toutes les harmoniques que l'on souhaite mesurer.

On peut alors développer $e_{a1}$ et $e_{a2}$ comme suit :

$$\begin{cases} e_{a1} = \sum_{k=0}^{\infty} E_k \sin(w_k t) \\ e_{a2} = \sum_{k=0}^{\infty} E_k \sin(w_k t - \varphi_k) \end{cases}$$

où $E_k$ est l'amplitude de l'harmonique k (k étant un nombre naturel) et $W_k$ est la pulsation ou fréquence angulaire de l'harmonique.

En calculant donc la tension du point milieu comme point de mesure lorsque les deux interrupteurs S1A et S1A' du pied de pont sont fermés, la phase PA se trouvant donc dans un état « roue libre »,

on obtient :

$$V_{OM} = \frac{e_{a2} - e_{a1}}{2} = \sum_{k=0}^{\infty}\left(\frac{E_k}{2}\sin(w_k t) - \frac{E_k}{2}\sin(w_k t - \varphi_k)\right)$$

$$= \sum_{k=0}^{\infty}\left(\frac{E_k}{2}(1 - \cos\varphi_k)\sin(w_k t) + \frac{E_k}{2}\sin(\varphi_k)\cos(w_k t)\right)$$

$$= \sum_{k=0}^{\infty}\left(A_k E_k \sin(w_k t + \phi_k)\right)$$

avec

$$\begin{cases} A_k = \dfrac{1}{2}\sqrt{2 - 2\cos\varphi_k} \\ \phi_k = \arctan\dfrac{\sin\varphi_k}{1 - \cos\varphi_k} \end{cases}$$

Etant donné que la force électromotrice totale d'une phase peut s'écrire de la façon suivante :

$$FEM = e_{a2} + e_{a1} = \sum_{k=0}^{\infty}\left(E_k \sin(w_k t) + E_k \sin(w_k t - \varphi_k)\right)$$

$$= \sum_{k=0}^{\infty}\left(E_k(1 + \cos\varphi_k)\sin(w_k t) - E_k \sin(\varphi_k)\cos(w_k t)\right)$$

$$= \sum_{k=0}^{\infty} A'_k \left(E_k \cos(w_k t - \phi_k')\right)$$

avec

$$\begin{cases} A_k' = \sqrt{2 + 2\cos\varphi_k} \\ \phi_k' = \arctan\dfrac{\sin\varphi_k}{1 + \cos\varphi_k} \end{cases}$$

Il en résulte que la mesure de $V_{OM}$ permet une mesure directe et fidèle des forces électromotrices (FEM) de chaque phase du moteur 3 à courant alternatif si la FEM ne contient pas d'harmonique.

On obtient donc une image de la FEM mais dont chaque composante harmonique est atténuée d'un facteur $\dfrac{A_k}{A_k'}$ et déphasée d'un angle $\phi_k - \phi_k'$.

avec

$$\text{avec} \begin{cases} \dfrac{A_k}{A_k'} = \dfrac{1}{2}\sqrt{\dfrac{1-\cos\varphi_k}{1+\cos\varphi_k}} \\ \phi_k - \phi_k' = \arctan\dfrac{\sin\varphi_k}{1-\cos\varphi_k} - \arctan\dfrac{\sin\varphi_k}{1+\cos\varphi_k} \end{cases}$$

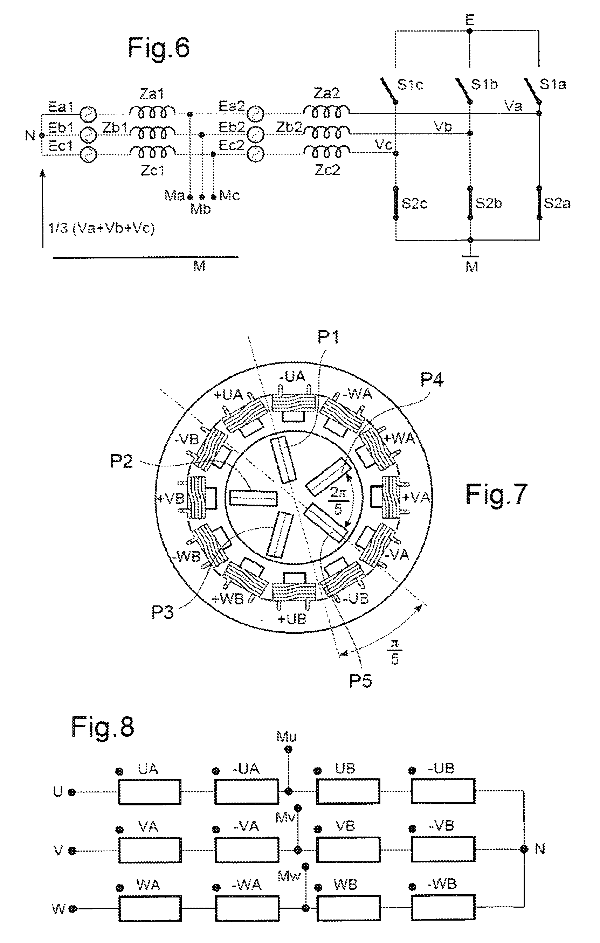

A titre d'exemple, une machine à 5 paires de pôles et 12 dents appelée par les hommes du métier une 12-10 bobinée (voir par exemple la figure 7) permet d'obtenir un déphasage de $\dfrac{\pi}{6}$ entre les deux demi-bobines.

On obtient ainsi les facteurs d'atténuation et les phases suivantes :

$$\begin{cases} \dfrac{A}{A'} = \sqrt{\dfrac{1-\cos\varphi}{1+\cos\varphi}} \\ \phi - \phi' = \arctan\dfrac{\sin\varphi}{1-\cos\varphi} - \arctan\dfrac{\sin\varphi}{1+\cos\varphi} \end{cases}$$

Le facteur d'atténuation ainsi que le déphasage sont des paramètres fixes et connus dépendant seulement de la construction du moteur 3. La FEM peut donc être mesurée facilement, ceci pour chacune des phases du moteur et sans avoir recours ni à des capteurs supplémentaires, ni à des estimations ou calculs complexes.

Ce calcul peut aussi être mené sans difficultés de manière analogue avec des impédances non égales en valeurs et/ou des FEM non égales en amplitudes à partir du moment où l'on connaît le rapport des FEM ou des impédances.

On accède donc à la force électromotrice du moteur 3 sans retard, sans perturbations et il n'y a pas de filtrage spécifique nécessaire.

Grâce à ce montage, on met donc en oeuvre un procédé de mesure de la force électromotrice dans lequel on mesure une tension entre le point de mesure d'un enroulement d'au moins une phase et un potentiel prédéfini pendant que l'onduleur ait commuté les phases concernées en roue libre, le point de mesure étant choisi de manière à ce qu'il divise l'enroulement en une première et une seconde parties telles que les forces électromotrices induites des deux parties soient déphasées l'une par rapport à l'autre.

On déduit alors des mesures de tension pour chacune des phases la force électromotrice pour chacune des phases du moteur et on peut commander l'onduleur en fonction des forces électromotrices mesurées.

Selon un exemple de réalisation l'onduleur 5 est configuré pour commuter de façon synchronisée l'ensemble des phases en roue libre pour permettre la mesure simultanée des tensions pour chaque phase du moteur.

Ceci est montré à titre d'exemple sur la figure 3 montrant des commandes PWM (pour « pulse width modulation » en anglais, c'est-à-dire MLI ou modulation de largeur d'impulsion en français) centrées.

Sur cette figure, PWM S1A représente la commande PWM de l'interrupteur S1A, PWM S1A' représente la commande PWM de l'interrupteur S1A', PWM S1B représente la commande PWM de l'interrupteur S1B, PWM S1B' représente la commande PWM de l'interrupteur S1B', PWM S1C représente la commande PWM de l'interrupteur S1C et PWM S1C' représente la commande PWM de l'interrupteur S1C'.

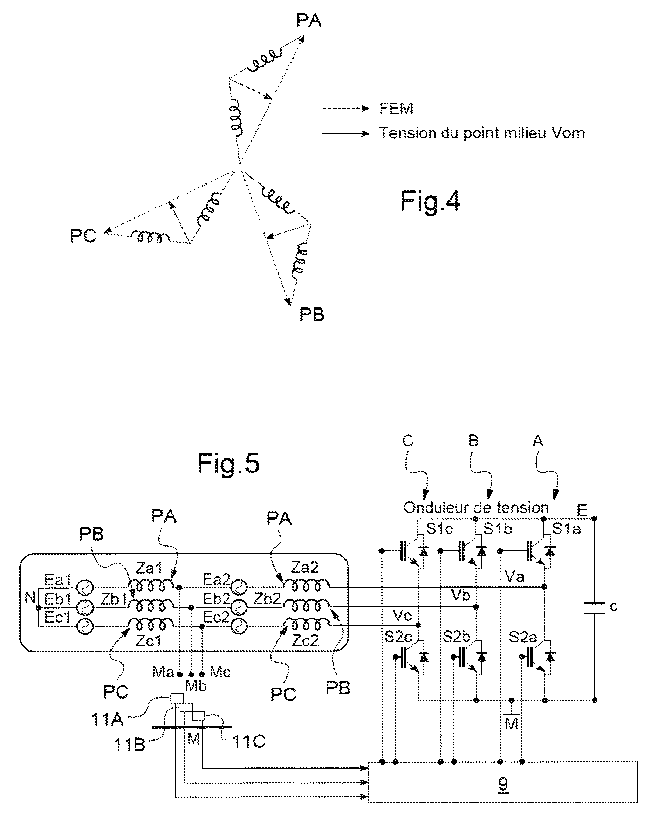

La figure 4 montre un digramme qui explique le lien entre les FEMs de chaque phase et les mesures de tension au point milieu des enroulements de chaque phase du moteur. On comprend qu'il s'agit d'une relation vectorielle (ce qui explique l'existence du déphasage et du gain).

La présente invention peut aussi être appliquée de manière analogue à l'exemple précédent à un onduleur standard 5 et un moteur triphasé 3 à point neutre et comportant des enroulements à point milieu, comme cela est représenté sur la figure 5.

L'onduleur 5 comporte dans cet exemple trois branches A, B et C avec respectivement deux éléments de commutation par branche respectivement S1a, S2a, S1b, S2b, et S1c, S2c.

Le moteur 3 comporte sur au moins un enroulement d'au moins une phase un point de mesure d'une tension par rapport à un potentiel prédéfini, le point de mesure étant choisi de manière à ce qu'il divise l'enroulement en une première et une seconde parties (ici Za1 et Za2 pour la phase A, Zb1 et Zb2 pour la phase B et Zc1 et Zc2 pour la phase C) telles que les forces électromotrices induites des deux parties d'un enroulement d'une phase soient déphasées l'une par rapport à l'autre.

Dans le présent exemple, ces points de mesure sont avantageusement confondus avec les points milieux Ma, Mb et Mc des enroulements des phases PA, PB et PC.

Des moyens 11A, 11B et 11C de mesure de la tension entre les points de mesure Ma, Mb et Mc et un potentiel prédéfini, par exemple la masse M du circuit, pendant que l'onduleur ait commuté les phases concernées A, B, C en roue libre sont prévus et reliés à l'unité de contrôle 9.

Plus en détail, on se réfère à la figure 6 qui représente le même circuit que la figure 5 dont les éléments de commutation S1a, S2a, S1b, S2b, et S1c, S2c ont été représentés schématiquement par des interrupteurs.

Comme on le constate, les interrupteurs du pied de chaque branche, c'est-à-dire les interrupteurs S2a, S2b, et S2c sont fermés, c'est-à-dire que les phases A, B et C aient été commutées par l'onduleur 5 en roue libre. De plus lorsque les interrupteurs S2A S2B S2C sont fermés la tension du point neutre vaut 0, on retrouve donc un schéma équivalent à la figure 2.

On peut donc déterminer de manière analogue à l'exemple des figures 1 à 4 la force électromotrice FEM de chaque phase, individuellement ou ensemble de façon synchronisée.

Comme expliqué précédemment, l'application de la présente invention nécessite de choisir un point de mesure de sorte que l'enroulement d'une phase soit divisé en une première et une seconde parties tel que les forces électromotrices induites des deux parties soient déphasées l'une par rapport à l'autre.

Ceci peut être obtenu, par exemple grâce à l'utilisation d'un moteur électrique à pas fractionnaire (moteur polyphasé à pas fractionnaire), c'est-à-dire une machine dont le pas mécanique correspond à une fraction de l'angle électrique.

Une machine à pas fractionnaire présente la particularité de posséder des enroulements appartenant à la même phase, mais déphasé électriquement. Autrement dit, dans une machine à pas fractionnaire, les enroulements d'une même phase ont des forces électromotrices induites déphasées entre elles.

On donne l'exemple sur la figure 7 d'une machine électrique (moteur) communément appelée 12 — 10 soit douze encoches avec leurs enroulements +UA, -UA, +VA, -VA, +WA, -WB, +UB, -UB, +VB, -VB, +WB, -WB, et 10 pôles (5 paires de pôles P1, P2, P3, P4, P5).

Les paires de pôles sont décalées d'un pas de 2n /5, tandis que les enroulements sont décalés de 2n /12.

Selon la nomenclature, un enroulement désigné par les mêmes lettres, mais possédant un signe inverse est bobiné dans le sens opposé. Ainsi, +UA est bobiné dans le sens opposé de -UA.

Dans ce moteur, les trois phases sont désignées par U, V et W, chaque phase présentant quatre enroulements dont la première lettre désigne l'appartenance à la phase, c'est-à-dire que la phase U présente les enroulements +UA, -UA, +UB et -UB.

En fonction des caractéristiques souhaitées du moteur, on peut envisager deux façons de câblage pour la mise en oeuvre de la présente invention pour mesurer directement la force électromotrice de chaque phase.

Selon une première façon représentée sur la figure 8, les quatre enroulements d'une même phase sont disposés en série et le point de mesure (Mu, Mv, et Mw) pour mesurer la tension correspondant à la force électromotrice d'une phase est le point milieu entre d'une part deux enroulements en série adjacents d'une même phase, par exemple +UA et -UA, et d'autre part les deux autres enroulements adjacents en série de la même phase, disposés en face des premiers enroulement, c'est-à-dire +UB et -UB.

Ainsi, à titre d'exemple, le point de mesure Mu pour la phase U, est choisi de manière à ce que l'enroulement de cette même phase (l'enroulement de la phase U est formé des bobinages ou enroulements +UA, -UA, +UB, -UB) est divisé en une première partie formée par +UA, et -UA et une seconde partie formée par +UB et -UB tel que les forces électromotrices induites de ces deux parties soient déphasées.

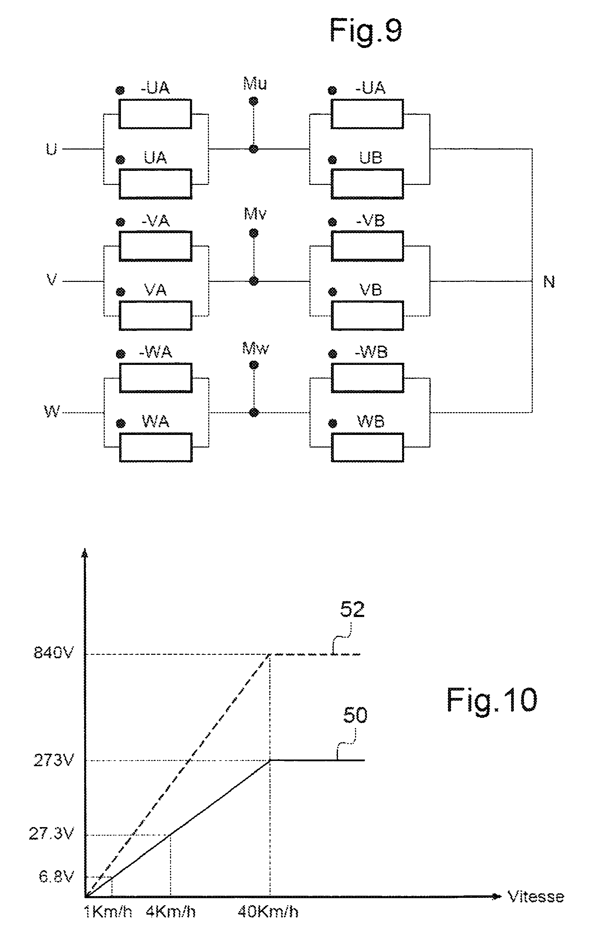

Selon une deuxième façon représentée sur la figure 9, les bobinages aller et retour (par exemple UA et -UA) d'une même phase sont disposés en parallèle et le point de mesure (Mu, Mv ou Mw) pour mesurer la tension correspondant à la force électromotrice d'une phase est le point milieu entre d'une part deux enroulements adjacents en parallèles d'une même phase, par exemple +UA et -UA, et d'autre part les deux autres enroulements en parallèle adjacents de la même phase, disposés en face des premiers enroulements, c'est-à-dire +UB et -UB.

La figure 10 montre à titre d'exemple pour un véhicule électrique en fonction de la vitesse l'amplitude des mesures de tension $V_{OM}$ en trait plein selon la courbe 50 et la force électromotrice déduite selon la courbe 52 en traits interrompus.

Comme cela est montré sur les figures 1 et 5, l'unité 9 de contrôle du moteur est reliée auxdits moyens de mesure 11A, 11B et 11C et est configurée pour déduire du résultat de mesure pour chaque phase la force électromotrice pour chacune des phases du moteur et pour commander l'onduleur en fonction des forces électromotrices mesurées.

On parle alors de commande « sans capteur » puisqu'il n'y a pas de capteur de position qui mesure directement la grandeur physique de position.

Outre la simplicité du contrôle de la machine qui résulte de l'utilisation de la mesure directe de la FEM, on peut envisager la commande sans capteur de position.

Certes, à l'arrêt, la position n'est pas connue, mais il suffit d'exciter le stator avec suffisamment de courant pour mettre en mouvement le rotor, si la FEM engendrée est suffisamment importante, alors l'unité de contrôle 9 peut de plus déduire la position grâce à la mesure de FEM. L'unité 9 peut alors calculer correctement les tensions à appliquer à chaque phase par des commandes PWM pour obtenir d'une part le couple moteur et le sens de rotation demandés.

Une telle phase de démarrage, si elle est courte, peut-être imperceptible par le conducteur.

Prenons un exemple de réducteur de rapport 10 et de roues de diamètre 70cm. A 40km/h, la machine tourne à 3000tr.min$^{-1}$. A 1Km/h, la machine tourne à 1.25 tr.s$^{-1}$ ce qui correspond à (0.125 tour de roue en 1s). Il suffirait en réalité d'un tour électrique pour identifier facilement l'angle du rotor. Dans l'exemple de la machine 12-10 décrit ci-dessus, il suffirait alors 1/5 de tour soit 200ms (0.025tour de roue). Ce déplacement serait imperceptible par le conducteur car cela correspond à 5,5cm de déplacement.

La FEM mesurée vaudrait 6.8V (voir figure 10). Si la résolution de la mesure est suffisante, le calculateur pourrait calculer pour retrouver la position du rotor.

Par ailleurs, l'unité de contrôle 9 est configurée pour déduire la position angulaire du moteur à partir des passages à zéro des forces électromotrices de chaque phase.

En effet, la détection des passages à zéro est une opération simple à réaliser via un circuit électronique ou par un logiciel.

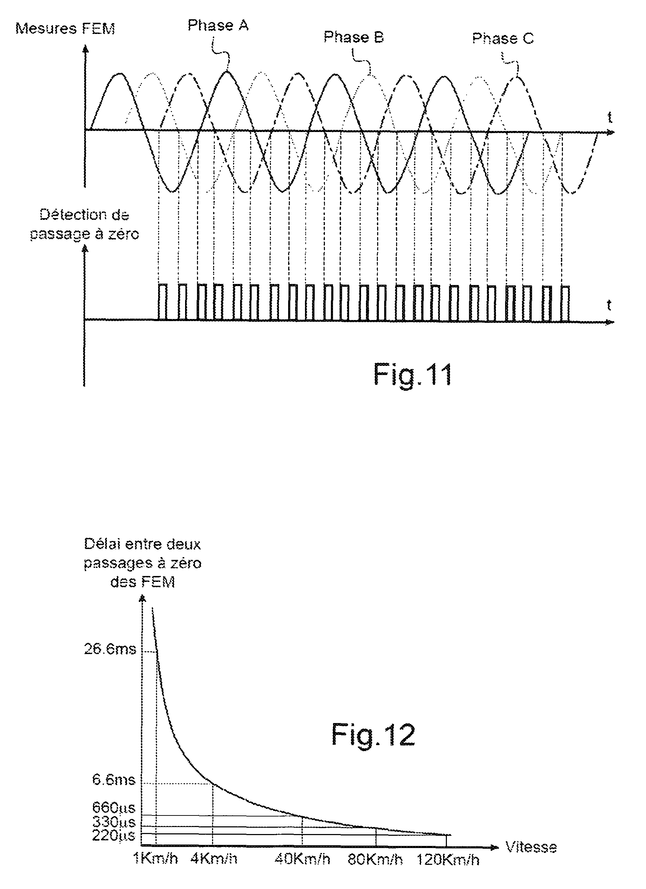

En référence à la figure 11, pour un moteur triphasé, on dénombre deux passages à zéro par période et par phase. Etant donné le déphasage entre phases, on dénombre au total six passages à zéro par période. Au passage à zéro de la mesure de FEM, on a directement une information sur la position angulaire du moteur 3 et cela sans calcul. On obtient donc six acquisitions de position par période électrique, ce qui est largement suffisant dans de nombreuses applications où la position angulaire du rotor n'a pas besoin d'être précisément connue à tout instant.

La figure 12 montre le délai entre deux passages à zéro des FEM mesurées en fonction de la vitesse d'un véhicule automobile électrique pour une application de machine à 12 encoches et 5 paires de pôles avec un réducteur de 10 et des roues de 70cm de diamètre.

Selon encore un autre aspect l'unité de contrôle 9 est configurée pour déduire de la mesure des forces électromotrices de chaque phase du moteur un diagnostic.

En effet, ces mesures permettent de façon non intrusive de détecter une défaillance par exemple d'une phase du moteur et de générer un signal d'alerte.

Par exemple, on peut détecter si l'amplitude de la force électromotrice d'une phase est inférieure à un seuil prédéterminé.

Même avec une phase défaillante, on peut encore rouler avec le véhicule et l'utilisateur peut se rendre dans une station de maintenance et on peut adapter les commandes PWM pour tenir compte de la phase défaillante.

On comprend donc que grâce à l'invention, on peut mesurer facilement et directement la force électromotrice de chaque phase d'un moteur. Il n'y a plus besoin d'un capteur spécifique. Les circuits de contrôle du moteur se trouvent alors simplifiés et moins onéreux.

Bien entendu, la présente invention s'applique à tout moteur électrique à courant alternatif peu importe le nombre de phases.

On rappelle encore que par moteur électrique, on entend une machine électrique au sens large, c'est-à-dire un moteur de propulsion si la machine est alimenté électriquement ou un générateur de courant en cas de commutation de l'onduleur en mode charge pour récupérer l'énergie électrique produite par le moteur.

## Revendications

**1.** Dispositif électrique (1) comportant un moteur électrique à courant alternatif (3) et un onduleur (5) de commande de la / des phase(s) du moteur (3), **caractérisé en ce que** le moteur (3) comporte sur au moins un enroulement d'au moins une phase (PA, PB, PC) un point de mesure (Ma, Mb, Mc) d'une tension par rapport à un potentiel prédéfini (M), le point de mesure (Ma, Mb, Mc) étant choisi de manière à ce qu'il divise l'enroulement en une première (Za1; Zb1; Zc1) et une seconde parties ( Za2 ; Zb2 ; Zc2) tel que les forces électromotrices ($e_{a1}$, $e_{a2}$) induites des deux parties soient déphasées l'une par rapport à l'autre et des moyens de mesure (11A; 11B; 11C) de la tension entre le point de mesure et le potentiel prédéfini.

**2.** Dispositif selon la revendication 1, **caractérisé en ce que** les moyens de mesure (11A; 11B; 11C) de la tension entre le point de mesure et le potentiel prédéfini sont configurés de manière à mesurer la tension pendant que l'onduleur (5) ait commuté les phases concernées en roue libre.

**3.** Dispositif selon la revendication 1 ou 2, **caractérisé en ce que** les enroulements du moteur (3) sont des enroulements

EP 2 400 659 B1

à point milieu (Ma, Mb, Mc) et **en ce que** le point de mesure est le point milieu de l'enroulement.

4.  Dispositif selon l'une quelconque des revendications 1 à 3, **caractérisé en ce que** la force électromotrice induite dans chacune des deux parties d'un enroulement est d'amplitude sensiblement égale.

5.  Dispositif selon l'une quelconque des revendications 1 à 4, **caractérisé en ce que** l'onduleur (5) est configuré pour commuter de façon synchronisée l'ensemble des phases en roue libre pour permettre la mesure simultanée des tensions pour chaque phase du moteur (3).

6.  Dispositif selon l'une quelconque des revendications 1 à 5, **caractérisé en ce que** l'onduleur (5) est un onduleur triphasé standard.

7.  Dispositif selon l'une quelconque des revendications 1 à 5, **caractérisé en ce que** l'onduleur est un onduleur (5) pont triphasé en H.

8.  Dispositif selon l'une quelconque des revendications 1 à 7, **caractérisé en ce que** le moteur électrique à courant alternatif (3) est un moteur électrique polyphasé dont le pas mécanique correspond à une fraction de l'angle mécanique.

9.  Dispositif selon l'une quelconque des revendications 1 à 8, **caractérisé en ce que** le moteur électrique à courant alternatif (3) est un moteur électrique triphasé à courant alternatif.

10.  Dispositif selon l'une quelconque des revendications 1 à 9, **caractérisé en ce qu'**il comprend une unité de contrôle du moteur (9) reliée auxdits moyens de mesure (11A, 11B, 11C) et configurée pour déduire du résultat de mesure pour chaque phase la force électromotrice pour chacune des phases du moteur et pour commander l'onduleur (5) en fonction des forces électromotrices mesurées.

11.  Dispositif selon la revendication 10, **caractérisé en ce que** l'unité de contrôle (9) est configurée pour déduire la position angulaire du moteur (3) à partir des passages à zéro des forces électromotrices de chaque phase.

12.  Procédé de mesure de la force électromotrice d'un dispositif électrique (1) comportant un moteur électrique à courant alternatif (3) et un onduleur de commande (5) de la / des phase(s) du moteur, **caractérisé en ce que**

    - on mesure une tension entre le point de mesure (Ma, Mb, Mc) d'un enroulement d'au moins une phase (PA, PB, PC) et un potentiel prédéfini (M), le point de mesure étant choisi de manière à ce qu'il divise l'enroulement en une première (Za1; Zb1; Zc1) et une seconde parties ( Za2; Zb2; Zc2) telles que les forces électromotrices induites des deux parties soient déphasées l'une par rapport à l'autre.

13.  Procédé selon la revendication 12, **caractérisé en ce que** l'on mesure une tension entre le point de mesure (Ma, Mb, Mc) d'un enroulement d'au moins une phase (PA, PB, PC) et un potentiel prédéfini (M) pendant que l'onduleur ait commuté les phases concernées en roue libre.

14.  Procédé selon la revendication 12 ou 13, **caractérisé en ce que** les enroulements du moteur (3) sont des enroulements à point milieu (Ma, Mb, Mc) et **en ce que** le point de mesure est le point milieu de l'enroulement.

15.  Procédé selon l'une quelconque des revendications 12 à 14, **caractérisé en ce que** la force électromotrice induite dans chacune des deux parties d'un enroulement est d'amplitude sensiblement égale.

16.  Procédé selon l'une quelconque des revendications 12 à 15, **caractérisé en ce que** l'on commute de façon synchronisée, par exemple par une modulation de la largeur d'impulsion, l'ensemble des phases en roue libre pour permettre la mesure simultanée des tensions pour chaque phase du moteur (3).

17.  Procédé selon l'une quelconque des revendications 12 à 15, **caractérisé en ce que** l'onduleur (5) est un onduleur triphasé standard.

18.  Procédé selon l'une quelconque des revendications 12 à 15, **caractérisé en ce que** l'onduleur (5) est un onduleur pont triphasé en H.

**19.** Procédé selon l'une quelconque des revendications 12 à 18, **caractérisé en ce que** le moteur électrique à courant alternatif (3) est un moteur électrique polyphasé dont le pas mécanique correspond à une fraction de l'angle électrique.

**20.** Procédé selon l'une quelconque des revendications 12 à 19, **caractérisé en ce que** le moteur électrique à courant alternatif (3) est un moteur électrique triphasé.

**21.** Procédé selon les revendications 12 à 20, **caractérisé en ce que** l'on déduit des mesures de tension pour chacune des phases (PA, PB, PC) la force électromotrice pour chacune des phases du moteur et on commande l'onduleur en fonction des forces électromotrices mesurées.

**22.** Procédé selon la revendication 21, **caractérisé en ce que** l'on déduit la position angulaire du moteur à partir des passages à zéro des forces électromotrices de chaque phase (PA, PB, PC).

**23.** Procédé selon l'une quelconque des revendications 12 à 22, **caractérisé en ce que** l'on déduit de la mesure des forces électromotrices de chaque phase du moteur un diagnostic et **en ce que** l'on génère un signal d'alerte en cas de défaillance d'une des phases.

**Claims**

**1.** Electric device (1) comprising an alternating current electric motor (3) and a control inverter (5) for controlling the phase or phases of the motor (3), **characterized in that** the motor (3) comprises, on at least one winding of at least one phase (PA, PB, PC), a point (Ma, Mb, Mc) for measuring a voltage relative to a predefined potential (M), the measurement point (Ma, Mb, Mc) being chosen so that it divides the winding into a first (Za1; Zb1; Zc1) and a second ( Za2; Zb2; Zc2) portion such that the electromotive forces ($e_{a1}$, $e_{a2}$) induced in the two portions are phase-shifted relative to one another and means (11A; 11B; 11C) for measuring the voltage between the measurement point and the predefined potential.

**2.** Device according to Claim 1, **characterized in that** the means (11A; 11B; 11C) for measuring the voltage between the measurement point and the predefined potential are configured so as to measure the voltage while the inverter (5) has switched the phases concerned to freewheeling mode.

**3.** Device according to Claim 1 or 2, **characterized in that** the windings of the motor (3) are windings with centre point (Ma, Mb, Mc) and **in that** the measurement point is the centre point of the winding.

**4.** Device according to any one of Claims 1 to 3, **characterized in that** the electromotive force induced in each of the two portions of a winding is of substantially equal amplitude.

**5.** Device according to any one of Claims 1 to 4, **characterized in that** the inverter (5) is configured to synchronously switch all the phases to freewheeling mode to allow for the simultaneous measurement of the voltages for each phase of the motor (3).

**6.** Device according to any one of Claims 1 to 5, **characterized in that** the inverter (5) is a standard three-phase inverter.

**7.** Device according to any one of Claims 1 to 5, **characterized in that** the inverter is an H-configuration three-phase bridge inverter (5).

**8.** Device according to any one of Claims 1 to 7, **characterized in that** the alternating current electric motor (3) is a polyphase electric motor whose mechanical step corresponds to a fraction of the mechanical angle.

**9.** Device according to any one of Claims 1 to 8, **characterized in that** the alternating current electric motor (3) is an alternating current three-phase electric motor.

**10.** Device according to any one of Claims 1 to 9, **characterized in that** it comprises a motor control unit (9) linked to said measurement means (11A, 11B, 11C) and configured to deduce, from the measurement result for each phase, the electromotive force for each of the phases of the motor and to control the inverter (5) according to the measured electromotive forces.

**11.** Device according to Claim 10, **characterized in that** the control unit (9) is configured to deduce the angular position of the motor (3) from the zero crossings of the electromotive forces of each phase.

**12.** Method for measuring the electromotive force of an electric device (1) comprising an alternating current electric motor (3) and a control inverter (5) for controlling the phase or phases of the motor, **characterized in that**

- a voltage is measured between the measurement point (Ma, Mb, Mc) of a winding of at least one phase (PA, PB, PC) and a predefined potential (M), the measurement point being chosen so that it divides the winding into a first (Za1; Zb1; Zc1) and a second (Za2; Zb2; Zc2) portion such that the electromotive forces induced in the two portions are phase-shifted relative to one another.

**13.** Method according to Claim 12, **characterized in that** a voltage is measured between the measurement point (Ma, Mb, Mc) of a winding of at least one phase (PA, PB, PC) and a predefined potential (M) while the inverter has switched the phases concerned to freewheeling mode.

**14.** Method according to Claim 12 or 13, **characterized in that** the windings of the motor (3) are windings with centre point (Ma, Mb, Mc) and **in that** the measurement point is the centre point of the winding.

**15.** Method according to any one of Claims 12 to 14, **characterized in that** the electromotive force induced in each of the two portions of a winding is of substantially equal amplitude.

**16.** Method according to any one of Claims 12 to 15, **characterized in that** all the phases are switched synchronously, for example by a pulse width modulation, to freewheeling mode to allow for the simultaneous measurement of the voltages for each phase of the motor (3).

**17.** Method according to any one of Claims 12 to 15, **characterized in that** the inverter (5) is a standard three-phase inverter.

**18.** Method according to any one of Claims 12 to 15, **characterized in that** the inverter (5) is an H-configuration three-phase bridge inverter.

**19.** Method according to any one of Claims 12 to 18, **characterized in that** the alternating current electric motor (3) is a polyphase electric motor whose mechanical step corresponds to a fraction of the electrical angle.

**20.** Method according to any one of Claims 12 to 19, **characterized in that** the alternating current electric motor (3) is a three-phase electric motor.

**21.** Method according to Claims 12 to 20, **characterized in that** the electromotive force for each of the phases of the motor is deduced from the voltage measurements for each of the phases (PA, PB, PC) and the inverter is controlled according to the measured electromotive forces.

**22.** Method according to Claim 21, **characterized in that** the angular position of the motor is deduced from the zero crossings of the electromotive forces of each phase (PA, PB, PC).

**23.** Method according to any one of Claims 12 to 22, **characterized in that** a diagnosis is deduced from the measurement of the electromotive forces of each phase of the motor and **in that** a warning signal is generated in case of failure of one of the phases.

**Patentansprüche**

**1.** Elektrische Vorrichtung (1), die einen Wechselstrom-Elektromotor (3) und einen Wechselrichter (5) zur Steuerung der Phase(n) des Motors (3) aufweist, **dadurch gekennzeichnet, dass** der Motor (3) auf mindestens einer Wicklung mindestens einer Phase (PA, PB, PC) einen Messpunkt (Ma, Mb, Mc) einer Spannung bezüglich eines vordefinierten Potentials (M), wobei der Messpunkt (Ma, Mb, Mc) so gewählt wird, dass er die Wicklung in einen ersten (Za1; Zb1; Zc1) und einen zweiten Teil (Za2; Zb2; Zc2) aufteilt, derart, dass die induzierten elektromotorischen Kräfte ($e_{a1}$, $e_{a2}$) der zwei Teile zueinander phasenverschoben sind, und Messeinrichtungen (11A; 11B; 11C) der Spannung zwischen dem Messpunkt und dem vordefinierten Potential aufweist.

2. Vorrichtung nach Anspruch 1, **dadurch gekennzeichnet, dass** die Messeinrichtungen (11A; 11B; 11C) der Spannung zwischen dem Messpunkt und dem vordefinierten Potential so konfiguriert sind, dass sie die Spannung messen, während der Wechselrichter (5) die betroffenen Phasen in den Freilauf geschaltet hat.

3. Vorrichtung nach Anspruch 1 oder 2, **dadurch gekennzeichnet, dass** die Wicklungen des Motors (3) Wicklungen mit Mittelpunkt (Ma, Mb, Mc) sind, und dass der Messpunkt der Mittelpunkt der wicklung ist.

4. Vorrichtung nach einem der Ansprüche 1 bis 3, **dadurch gekennzeichnet, dass** die in jeden der zwei Teile einer Wicklung induzierte elektromotorische Kraft im Wesentlichen die gleiche Amplitude hat.

5. Vorrichtung nach einem der Ansprüche 1 bis 4, **dadurch gekennzeichnet, dass** der Wechselrichter (5) konfiguriert ist, um die Gesamtheit der Phasen synchron in den Freilauf zu schalten, um die gleichzeitige Messung der Spannungen für jede Phase des Motors (3) zu erlauben.

6. Vorrichtung nach einem der Ansprüche 1 bis 5, **dadurch gekennzeichnet, dass** der Wechselrichter (5) ein Standard-Drehrichter ist.

7. Vorrichtung nach einem der Ansprüche 1 bis 5, **dadurch gekennzeichnet, dass** der Wechselrichter ein Wechselrichter (5) mit dreiphasiger H-Brücke ist.

8. Vorrichtung nach einem der Ansprüche 1 bis 7, **dadurch gekennzeichnet, dass** der Wechselstrom-Elektromotor (3) ein Mehrphasen-Elektromotor ist, dessen mechanischer Schritt einem Bruchteil des mechanischen Winkels entspricht.

9. Vorrichtung nach einem der Ansprüche 1 bis 8, **dadurch gekennzeichnet, dass** der Wechselstrom-Elektromotor (3) ein Wechselstrom-Drehstrom-Elektromotor ist.

10. Vorrichtung nach einem der Ansprüche 1 bis 9, **dadurch gekennzeichnet, dass** sie eine Steuereinheit des Motors (9) enthält, die mit den Messeinrichtungen (11A, 11B, 11C) verbunden und konfiguriert ist, um vom Messergebnis für jede Phase die elektromotorische Kraft jede der Phasen des Motors abzuleiten, und um den Wechselrichter (5) abhängig von den gemessenen elektromotorischen Kräften zu steuern.

11. Vorrichtung nach Anspruch 10, **dadurch gekennzeichnet, dass** die Steuereinheit (9) konfiguriert ist, um die Winkelstellung des Motors (3) ausgehend von den Nulldurchgängen der elektromotorischen Kräfte jeder Phase abzuleiten.

12. Verfahren zur Messung der elektromotorischen Kraft einer elektrischen Vorrichtung (1), die einen Wechselstrom-Elektromotor (3) und einen Wechselrichter (5) zur Steuerung der Phase(n) des Motors aufweist, **dadurch gekennzeichnet, dass**

   - eine Spannung zwischen dem Messpunkt (Ma, Mb, Mc) einer Wicklung mindestens einer Phase (PA, PB, PC) und einem vordefinierten Potential (M) gemessen wird, wobei der Messpunkt so gewählt wird, dass er die Wicklung in einen ersten (Za1; Zb1; Zc1) und einen zweiten Teil (Za2; Zb2; Zc2) aufteilt, derart, dass die induzierten elektromotorischen Kräfte der zwei Teile zueinander phasenverschoben sind.

13. Verfahren nach Anspruch 12, **dadurch gekennzeichnet, dass** eine Spannung zwischen dem Messpunkt (Ma, Mb, Mc) einer Wicklung mindestens einer Phase (PA, PB, PC) und einem vordefinierten Potential (M) gemessen wird, während der Wechselrichter die betroffenen Phasen in den Freilauf geschaltet hat.

14. Verfahren nach Anspruch 12 oder 13, **dadurch gekennzeichnet, dass** die Wicklungen des Motors (3) Wicklungen mit Mittelpunkt (Ma, Mb, Mc) sind, und dass der Messpunkt der Mittelpunkt der Wicklung ist.

15. Verfahren nach einem der Ansprüche 12 bis 14, **dadurch gekennzeichnet, dass** die in jeden der zwei Teile einer Wicklung induzierte elektromotorische Kraft im Wesentlichen die gleiche Amplitude hat.

16. Verfahren nach einem der Ansprüche 12 bis 15, **dadurch gekennzeichnet, dass** die Gesamtheit der Freilaufphasen zum Beispiel durch eine Modulation der Impulsbreite synchron geschaltet wird, um die gleichzeitige Messung der Spannungen für jede Phase des Motors (3) zu erlauben.

17. Verfahren nach einem der Ansprüche 12 bis 15, **dadurch gekennzeichnet, dass** der Wechselrichter (5) ein Standard-Drehrichter ist.

18. Verfahren nach einem der Ansprüche 12 bis 15, **dadurch gekennzeichnet, dass** der Wechselrichter (5) ein Wechselrichter mit dreiphasiger H-Brücke ist.

19. Verfahren nach einem der Ansprüche 12 bis 18, **dadurch gekennzeichnet, dass** der Wechselstrom-Elektromotor (3) ein Mehrphasen-Elektromotor ist, dessen mechanischer Schritt einem Bruchteil des elektrischen Winkels entspricht.

20. Verfahren nach einem der Ansprüche 12 bis 19, **dadurch gekennzeichnet, dass** der Wechselstrom-Elektromotor (3) ein Drehstrom-Elektromotor ist.

21. Verfahren nach einem der Ansprüche 12 bis 20, **dadurch gekennzeichnet, dass** von den Spannungsmessungen für jede der Phasen (PA, PB, PC) die elektromotorische Kraft für jede der Phasen des Motors abgeleitet wird, und der Wechselrichter abhängig von den gemessenen elektromotorischen Kräften gesteuert wird.

22. Verfahren nach Anspruch 21, **dadurch gekennzeichnet, dass** die Winkelstellung des Motors ausgehend von den Nulldurchgängen der elektromotorischen Kräfte jeder Phase (PA, PB, PC) abgeleitet wird.

23. Verfahren nach einem der Ansprüche 12 bis 22, **dadurch gekennzeichnet, dass** von der Messung der elektromotorischen Kräfte jeder Phase des Motors eine Diagnose abgeleitet wird, und dass im Fall eines Ausfalls einer der Phasen ein Warnsignal erzeugt wird.

# Fig.1

# Fig.2

# Fig.3

Fig.4

- - - → FEM

──────→ Tension du point milieu Vom

Fig.5

EP 2 400 659 B1

# Fig.6

1/3 (Va+Vb+Vc)

# Fig.7

# Fig.8

# Fig.9

# Fig.10

Mesures FEM    Phase A    Phase B    Phase C

Détection de
passage à zéro

t

**Fig.11**

Délai entre deux
passages à zéro
des FEM

26.6ms

**Fig.12**

6.6ms

660µs
330µs
220µs

1Km/h  4Km/h    40Km/h    80Km/h  120Km/h    Vitesse

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6307336 B
- EP 1564882 A
- US 7489097 B